# EUROPEAN PATENT APPLICATION

(11) **EP 2 437 298 A1**
(43) Date of publication of application: **04.04.2012**
(21) Application number: 10780411.4
(22) Date of filing: 12.05.2010
(51) Int. Cl.: H01L 27/146, H01L 27/14, H01L 27/148, H04N 5/335

(54) **IMAGE PICKUP DEVICE AND METHOD OF ARRANGING IMAGE PICKUP ELEMENT**

(30) Priority: 29.05.2009 JP 2009130358
(71) Applicant: NEC TOSHIBA Space Systems, Ltd., Fuchu Tokyo 183-8551 (JP)
(72) Inventor: TAKEMURA Koji, Fuchu-shi Tokyo 183-8551 (JP); NOGUCHI Kazuhide, Fuchu-shi Tokyo 183-8551 (JP); SAKASHITA Takashi, Fuchu-shi Tokyo 183-8551 (JP)
(74) Representative: Robson, Aidan John
(86) International application number: PCT/JP2010/057999
(87) International publication number: WO 2010/137456

(57) **Abstract**

An image pickup apparatus is provided with: an optical system including a lens or a reflecting mirror; an image pickup device having a light-receiving surface on which light rays from the optical system are focused and a plurality of light-receiving pixels which generate charges on the light-receiving surface by the light rays; a bias voltage generation unit which supplies power to the image pickup device; a signal processing unit which processes a signal output from the image pickup device and outputs the processed signal as image data; and a control unit which inputs into the image pickup device a driving clock that controls transmission of the charges generate in the light-receiving pixels of the image pickup device. The image pickup device is bent so that distortion aberration present in the optical system is eliminated.

## Description

### {Technical Field}

The present invention relates to an image pickup apparatus (device) and a method of arranging an image pickup device (element) for correcting distortion aberration of an optical system.

### {Background Art}

To pick up an image of a moving object with a small amount of light and to pick up an image with a moving image pickup apparatus, as an image pickup device, used is a Time Delay Integration (TDI) type Charge Coupled Device (CCD) having a Time Delay Integration (TDI) function capable of securing a sufficiently high signal level by integration of signal components.

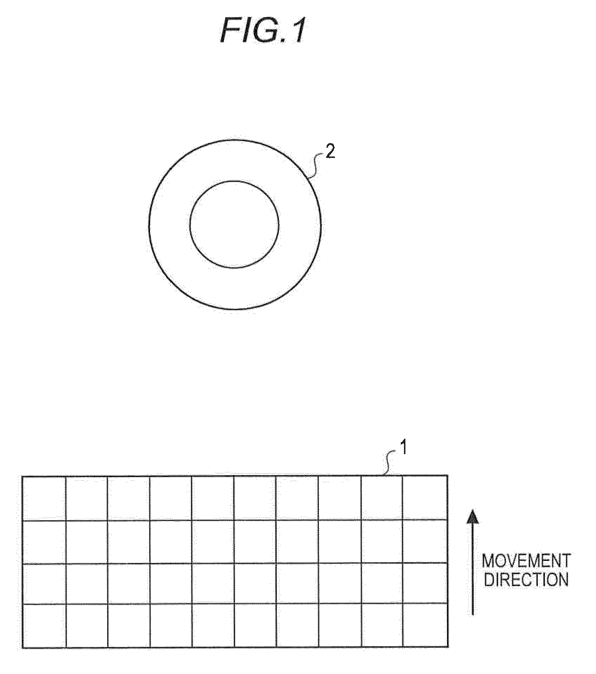

With respect to the operation of the TDI type CCD, referring to a diagram of Fig. 1 illustrating the principle of the operation of the TDI type CCD 1, the number of pixel rows is set to 4, an object 2 to be imaged stays in a stopped state; and an image pickup apparatus moves upward. As a result, charges obtained from each pixel are added to become the charge amount and thus the charge amount is proportional to the number of rows in the vertical direction. Accordingly, an increase in the signal level improves sensitivity.

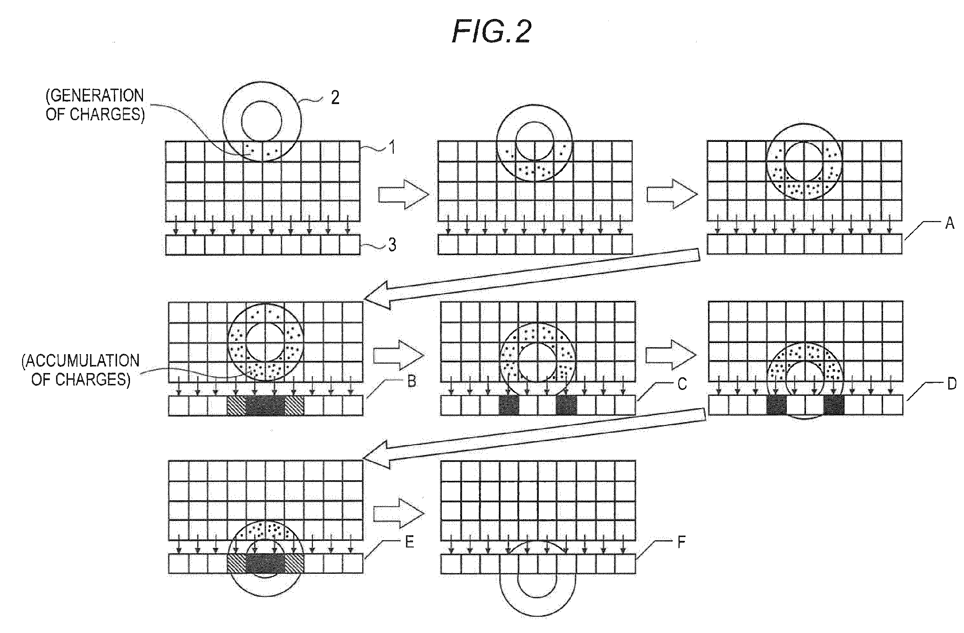

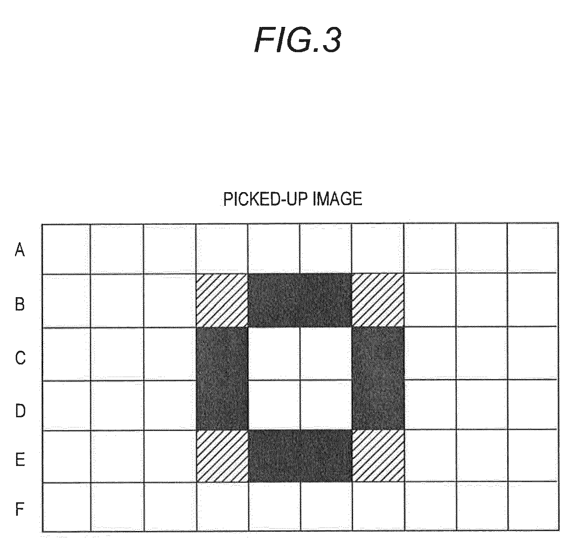

For example, as seen from the diagram of Fig. 2 illustrating an example of the operational flow of the TDI type CCD, the charges obtained by each pixel of the TDI type CCD 1 are added according to the movement of the image pickup apparatus, and thus an increased signal level is transmitted to a horizontal shift register 3, so that a picked-up image illustrated in Fig. 3 is obtained.

However, in general, to pick up an image with a CCD, light rays of the object to be imaged need to be appropriately focused on the CCD by an optical system using one lens or one reflecting mirror, or a plurality of lenses or reflecting mirrors.

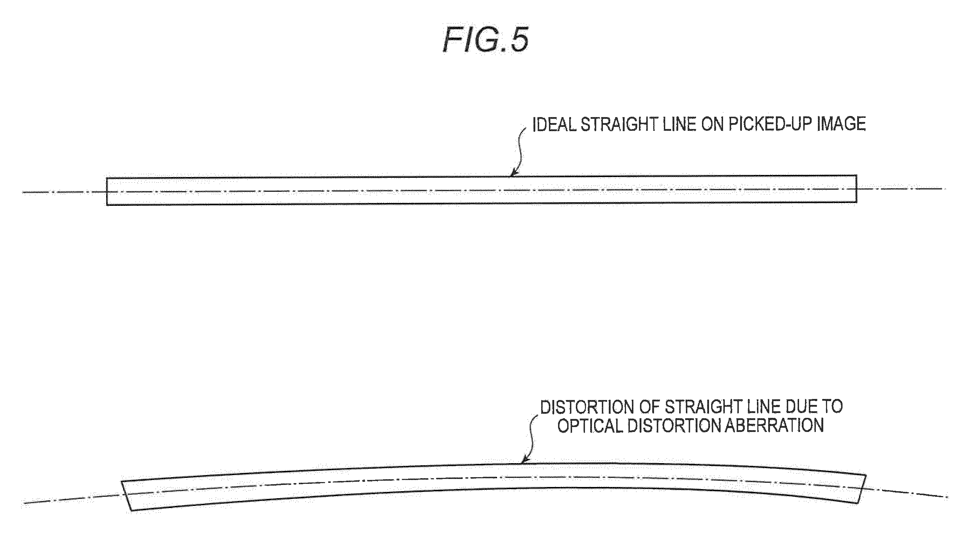

However, since the optical system has distortion aberration, at the peripheral portion of the picked-up image, the image becomes enlarged or reduced. For example, as illustrated in the lower portion of Fig. 5, there is a problem in that the straight line at the image surface side becomes a curved line at the side of a surface to be imaged.

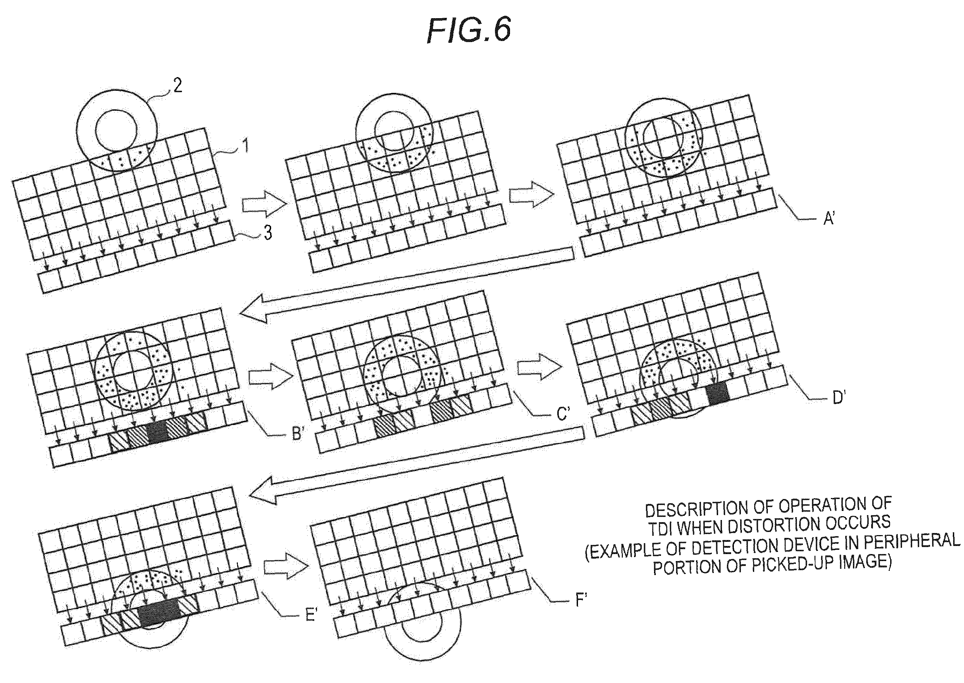

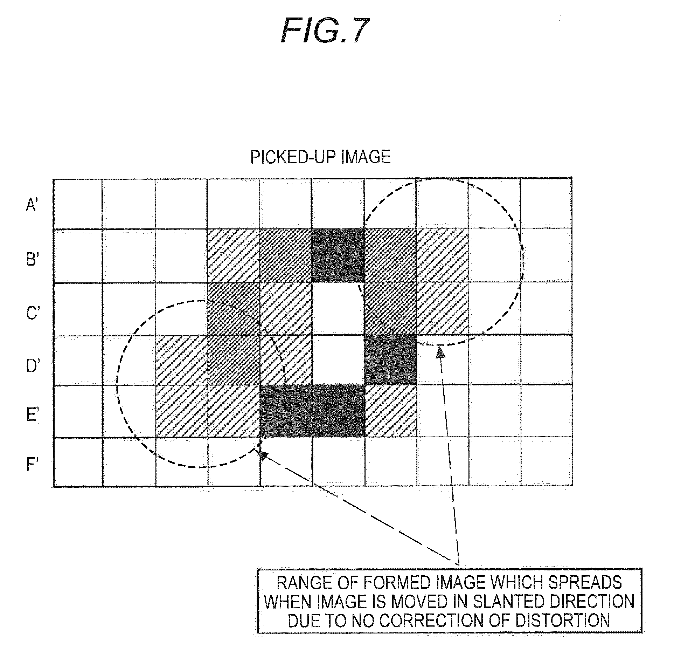

Therefore, in the case where the image pickup device is arranged without taking the distortion aberration into account, as illustrated in Figs. 6 and 7, particularly in the peripheral portion of the image, the image picking up is performed on the image pickup range where the pixels in the direction of a row to be subjected to the TDI are not coincident with the pixels in the front row, so that the image becomes unclean. Therefore, the Modulation Transfer Function (MTF) deteriorates.

However, if the optical system is designed to preferentially improve the performance such as observation width and resolution required for an optical sensor, there is a problem in that the size of the optical system becomes large. According to the increase in size of the optical system , the influence of the distortion of the image on the focal plane tends to be increased. Therefore, an approach of preventing the MTF from deteriorating by eliminating the distortion aberration is being increasingly required.

In general, it has been implemented adoption of a technique of correcting the distortion aberration by adding a lens or a reflecting mirror, and correction conveniently by an image process in the later stage of a system. However, in the former case, there are problems of an increase in weight, a decrease in light transmittance, and an increase in price and cost. In addition, in the latter case, the cost for system implementation is increased. Therefore, an approach of implementing the correction of the distortion aberration with a suppressed influence on the performance and cost of the system is preferable.

Therefore, Patent Document 1 discloses the invention where the pixel interval and the pixel area of the image pickup device are configured to be increased as goes from the center to the peripheral portion in order to correct the distortion caused by the distortion aberration.

### {Citation List}

### {Patent Literature}

Patent Document 1: Japanese Patent Application Laid-Open (JP-A) No. 01-094776

### {Summary of Invention}

### {Technical Problem}

However, the invention disclosed in Patent Document 1 has a problem of an increased pixel area which correspondingly increases the production cost.

In addition, there is a problem in that a charge diffusion rate may not be uniform and the quality of image deteriorates due to the biasing of the aperture effect, so that a value of the MTF may deteriorate.

Furthermore, there is a problem that in the invention disclosed in Patent Document 1, an image pickup apparatus such as a video camera is considered, but the use of the TDI type CCD is not presumed.

Therefore, an exemplary object of the present invention is to provide an image pickup apparatus and a method of arranging an image pickup device capable of eliminating distortion aberration at a low cost and picking up an image with a high quality of image on the presumption of use of a TDI type CCD.

### {Solution to Problem}

According to a first exemplary aspect of the present invention, there is provided an image pickup apparatus including: an optical system including a lens or a reflecting mirror; an image pickup device having a light-receiving surface on which light rays from the optical system are focused and a plurality of light-receiving pixels which generate charges on the light-receiving surface by the light rays; a bias voltage generation unit which supplies power to the image pickup device; a signal processing unit which processes a signal output from the image pickup device and outputs the processed signal as image data; and a control unit which inputs into the image pickup device a driving clock that controls transmission of the charges generated in the light-receiving pixels of the image pickup device, wherein the image pickup device is bent so that distortion aberration present in the optical system is eliminated.

According to a second exemplary aspect of the present invention, there is provided a method of arranging an image pickup device, the method including the steps of:
designing an image pickup apparatus which includes an optical system including a lens or a reflecting mirror, an image pickup device having a light-receiving surface on which a light ray from the optical system is focused and a plurality of light-receiving pixels which generate charges on the light-receiving surface by the light ray, a bias voltage generation unit which supplies power to the image pickup device, a signal processing unit which processes a signal output from the image pickup device and outputs the processed signal as image data, and a control unit which inputs into the image pickup device a driving clock that controls transmission of the charges generated in the light-receiving pixels of the image pickup device; calculating distortion aberration through simulation using an optical model at the time of designing; determining a shape used to eliminate the calculated distortion aberration; and producing the image pickup device in the determined shape and disposing the image pickup device at a position on which light rays from the optical system are focused.

### {Advantageous Effect of Invention}

In a typical image pickup apparatus and a typical method of arranging an image pickup device according to the present invention, the image pickup device is allowed to be bent in a shape capable of eliminating distortion aberration, so that it is possible to provide an image pickup apparatus and a method of arranging an image pickup device capable of eliminating distortion aberration at a low cost and picking up an image with a high quality of image on the presumption of use of a TDI type CCD.

### {Brief Description of Drawings}

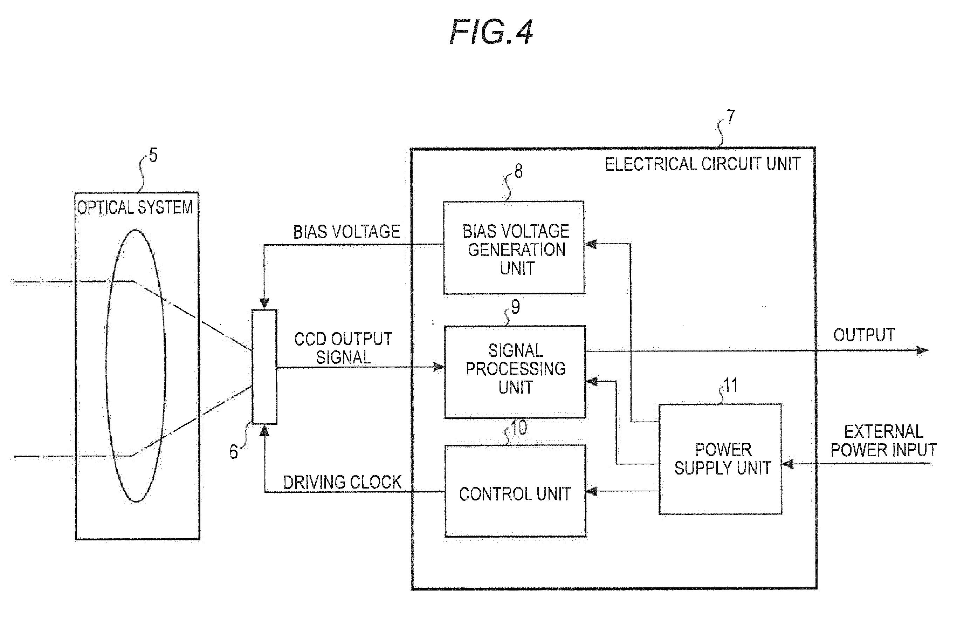

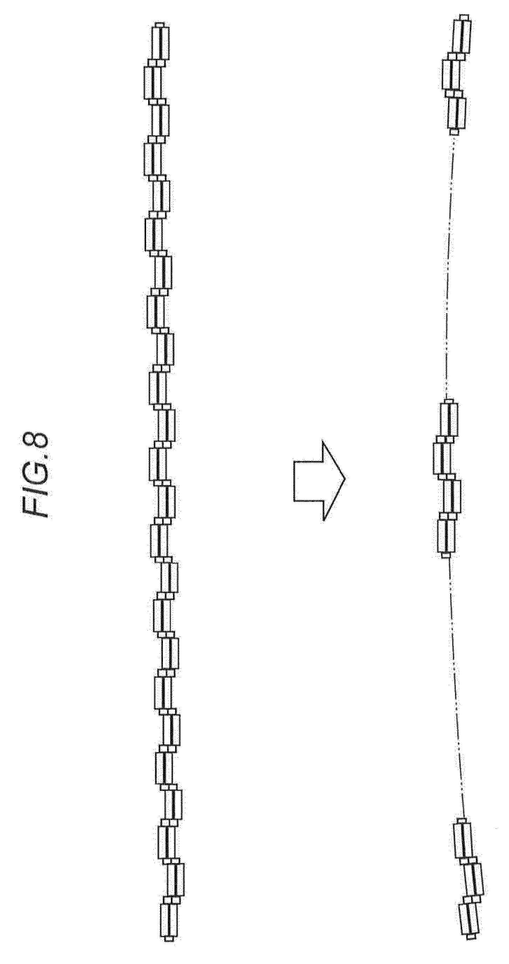

{Fig. 1} A diagram illustrates a principle of operations of a TDI type CCD.
{Fig. 2} A diagram illustrates an example of a flow of operations of the TDI type CCD.
{Fig. 3} An enlarged diagram illustrates a picked-up image of an object to be imaged, which is picked up by an image pickup apparatus using the TDI type CCD.
{Fig. 4} A diagram illustrates a configuration of a moving image pickup apparatus according to an embodiment of the present invention.
{Fig. 5} A diagram illustrates comparison of a case where a picked-up image is ideally formed and a case where an optical system has distortion aberration.
{Fig. 6} A diagram illustrates an example of a flow of operations of a TDI type CCD of a moving image pickup apparatus where an optical system has distortion aberration.
{Fig. 7} An enlarged diagram illustrates an example of a picked-up image of an object to be imaged in the case where an optical system has distortion aberration.
{Fig. 8} A diagram illustrates comparison of a general arrangement of light-receiving pixels of a TDI type CCD and an arrangement of light-receiving pixels included in the moving image pickup apparatus according to the embodiment.

### {Description of Embodiments}

### {Embodiments}

Hereinafter, embodiments of the present invention will be described with reference to the drawings. Herein, Fig. 4 is a diagram illustrating a configuration of a moving image pickup apparatus according to an embodiment of the present invention.

Referring to Fig. 4, the moving image pickup apparatus according to the embodiment includes an optical system 5 for forming an image of an object to be imaged, by using one lens, one reflecting mirror, or a plurality of lenses or reflecting mirrors.

The moving image pickup apparatus according to the embodiment includes a TDI type CCD 6 which is an image pickup device having a light-receiving surface on which light rays from the optical system 5 are focused and a plurality of light-receiving pixels which generate charges on the light-receiving surface by the light rays from the optical system 5.

In addition, the moving image pickup apparatus includes a bias voltage generation unit 8 which supplies power to the TDI type CCD 6, a signal processing unit 9 which processes a CCD output signal which is a signal output from the TDI type CCD 6 and outputs the processed signal as image data, and a control unit 10 which inputs a driving clock that controls transfer of the charges generated in the light-receiving pixels of the TDI type CCD 6 to the TDI type CCD 6.

Furthermore, the moving image pickup apparatus includes a power supply unit which converts external input power to predetermined voltage and current and supplies the converted voltage and current to the bias voltage generation unit 8, the signal processing unit 9, and the control unlit 10.

Fig. 8 is a diagram illustrating comparison of a general arrangement of light-receiving pixels of a TDI type CCD and an arrangement of light-receiving pixels included in the moving image pickup apparatus according to the embodiment. The upper portion of Fig. 8 illustrates the general arrangement of light-receiving pixels of the TDI type CCD, in which the light-receiving pixels are arranged horizontally.

On the other hand, the lower portion of Fig. 8 illustrates the arrangement of light-receiving pixels of the TDI type CCD which is the image pickup device in the moving image pickup apparatus according to the embodiment. Unlike the general case where light-receiving pixels are arranged horizontally, the light-receiving pixels are arranged in a curve having a curvature such as an arch so that the distortion aberration present in the optical system 5 is eliminated. The arch shape is a quadratic curve such as a circular are, and the type of the quadratic curve and whether the arch shape are convex or concave with respect to the optical system are determined according to the actual distortion aberration to be eliminated.

In this case, by performing a process of calculating distortion aberration through simulation using an optical model at the time of designing and determining the shape for eliminating the calculated distortion aberration and a process of producing the image pickup device in the shape determined in the above process and disposing the image pickup device at a position on which light rays from the optical system 5 are focused, the TDI type CCD 6 which is the image pickup device is installed in the moving image pickup apparatus according to the embodiment.

Herein, the shape of bending of the image pickup device may be a quadratic curve selected from one group consisting of a circular are, an elliptic are, a parabolic line, and a hyperbolic curve.

### {Operations According to Embodiment}

Next, operations of the moving image pickup apparatus according to the embodiment will be described in detail with reference to the drawings.

Herein, Fig. 5 is a diagram illustrating comparison of a case where a picked-up image is ideally formed and a case where optical system has distortion aberration. As illustrated in the upper portion of Fig. 5, in the case where a picked-up image is ideally formed, the image of an object to be imaged, having a shape of a straight line is formed as a straight line.

The lower portion of Fig. 5 illustrates the case where an optical system has distortion aberration. In this case, as illustrated in the lower portion of Fig. 5, the image of the object to be imaged in a straight line shape is formed to be distorted like an arch, particularly, in the peripheral portion of the image.

Fig. 6 is a diagram illustrating an example of a flow of operations of the TDI type CCD of the moving image pickup apparatus where the optical system has distortion aberration.

In Fig. 6, the formed image is distorted due to the distortion aberration present in the optical system, so that the light-receiving pixels excluding the portion corresponding to the object 3 to be imaged also generate charges.

An enlarged diagram of the image of the object to be imaged, which is picked up in the case of Fig. 6, is illustrated in Fig. 7. In Fig. 7, due to the charges generated by the light-receiving pixels other than the portion overlapping the object 3 to be imaged in Fig. 6, the image further spreads in comparison with an actual object to be imaged. Because of the image spreading, the image becomes clear, so that the MTF (Modulation Transfer Function) deteriorates.

In the embodiment, as illustrated in the lower portion of Fig. 8, the light-receiving pixels of the TDI type CCD are arranged in arch-shaped curve, so that the distortion aberration is to be eliminated. The lower portion of Fig. 8 illustrates the side surface of the TDI type CCD as seen from the direction in which the moving image pickup apparatus according to the embodiment is moved.

In the embodiment, in order to eliminate the distortion aberration, the arch shape of the TDI type CCD needs to be suitable to the to-be-eliminated distortion aberration. In this case, the distortion aberration is calculated through simulation using an optical model at the time of designing, and the shape for eliminating the calculated distortion aberration is determined.

Various methods of calculating the distortion aberration through the simulation using an optical model at the time of designing are considered. For example, a method of predicatively calculating a picked-up image of an actual optical system as a footprint shape through optical simulation is considered.

By the simulation using an optical model at the time of designing, it can be determined whether the shape of the arch bending is convex or concave with respect to the optical system, it can be determined whether the quadratic curve relating to the shape of the arch bending is a circular are, a hyperbolic curve, a parabolic line, or an elliptic arc, and a degree of the bending or the like can be determined.

After that, the optical system and the image pickup device are actually assembled, and the final shape and position of the TDI type CCD which is the image pickup device are produced and determined based on the result obtained through actual image pickup of the assembled image pickup apparatus.

In addition, in the embodiment of the present invention, although the light-receiving pixels of the TDI type CCD are arranged in a two-dimensional shape such as an arch, the present invention may be applied to correction of aberration other than the distortion aberration such as curvature of field by using a "bowl shape" which is a three-dimensional shape.

In addition, in the embodiment of the present invention, although the image pickup apparatus using the TDI type CCD is considered, other image pickup devices such as a linear image sensor or area image sensor may be used. In this case, a cross section of another image pickup device such as a linear image sensor or an area image sensor is considered to be a curved line suitable to eliminate the distortion aberration of the optical system.

Hereinbefore, although representative embodiments of the present invention are described, the present invention may be implemented in various forms without departing from the spirit and the scope of the invention defined by the claims. Therefore, the embodiments described above are only exemplary ones, and thus, the present invention should not be construed in a limitative sense. The scope of the present invention is indicated by the claims, but it is not restricted by the specification or the abstract. In addition, all equivalent modifications or alterations within the claims are considered within the scope of the present invention.

The present application is based upon and claims the benefit of priority from Japanese Patent Application No. 2009-130358 filed on May 29, 2009. The entire content disclosed in Japanese Patent Application No. 2009-130358 is hereby incorporated into the present application by reference.

### {Industrial Applicability}

The present invention is suitable for high resolution image pickup where distortion aberration with respect to a moving object with a small amount of light is eliminated, and can be used for an observation apparatus using a moving image pickup apparatus and a satellite which use a TDI type CCD.

### {Reference Signs List}

- 1: TDI type CCD
- 2: object to be imaged
- 3: horizontal shift register
- 5: optical system
- 6: TDI type CCD
- 7: electrical circuit
- 8: bias voltage generation unit
- 9: signal processing unit
- 10: control unit
- 11: power supply unit

## Claims

1. An image pickup apparatus comprising: an optical system including a lens or a reflecting mirror; an image pickup device having a light-receiving surface on which light rays from the optical system are focused and a plurality of light-receiving pixels which generate charges on the light-receiving surface by the light rays; a bias voltage generation unit which supplies power to the image pickup device; a signal processing unit which processes a signal output from the image pickup device and outputs the processed signal as image data; and a control unit which inputs into the image pickup device a driving clock that controls transmission of the charges generated in the light-receiving pixels of the image pickup device, wherein the image pickup device is bent so that distortion aberration present in the optical system is eliminated.

2. The image pickup apparatus according to claim 1, wherein
the shape of bending of the image pickup device is determined by calculating the distortion aberration through simulation using an optical model at the time of designing so that the calculated distortion aberration is eliminated.

3. The image pickup apparatus according to claim 2, wherein
the image pickup device is a Time Delay Integration (TDI) type Charge Coupled Device (CCD).

4. The image pickup apparatus according to claim 3, wherein
the shape of bending of the image pickup device is a quadratic curve selected from one group consisting of a circular are, an elliptic are, a parabolic line, and a hyperbolic curve.

5. The image pickup apparatus according to claim 3, wherein
the image pickup device has a three-dimensional bowl shape.

6. A method of arranging an image pickup device, the method comprising the steps of:
designing an image pickup apparatus which includes an optical system including a lens or a reflecting mirror, an image pickup device having a light-receiving surface on which a light ray from the optical system is focused and
a plurality of light-receiving pixels which generate charges on the light-receiving surface by the light ray, a bias voltage generation unit which supplies power to the image pickup device, a signal processing unit which processes a signal output from the image pickup device and outputs the processed signal as image data, and a control unit which inputs into the image pickup device a driving clock that controls transmission of the charges generated in the light-receiving pixels of the image pickup device;
calculating distortion aberration through simulation using an optical model at the time of designing;
determining a shape used to eliminate the calculated distortion aberration; and
producing the image pickup device in the determined shape and disposing the image pickup device at a position on which light rays from the optical system are focused.

7. The method of arranging an image pickup device according to claim 6, wherein the image pickup device is a Time Delay Integration (TDI) type Charge Coupled Device (CCD).

8. The method of arranging an image pickup device according to claim 7, wherein
in the determining of the shape, the shape used to eliminate the distortion aberration is a quadratic curve selected from a group consisting of a circular arc, an elliptic are, a parabolic line, and a hyperbolic curve.

9. The method of arranging an image pickup device according to claim 7, wherein
in the determining of the shape, the shape used to eliminate the distortion aberration is a three-dimensional bowl shape.
